# EUROPÄISCHE PATENTSCHRIFT

(11) **EP 2 710 394 B1**
(45) Veröffentlichungstag und Bekanntmachung des Hinweises auf die Patenterteilung: **29.04.2015**
(21) Anmeldenummer: 11749793.3
(22) Anmeldetag: 18.08.2011
(51) Int. Cl.: G01R 33/09

(54) **VORRICHTUNG UND VERFAHREN ZUR ZUSTANDSÜBERWACHUNG EINES ANLAGENBESTANDTEILS**
DEVICE AND METHOD FOR MONITORING THE STATE OF A SYSTEM COMPONENT
DISPOSITIF ET PROCÉDÉ DE CONTRÔLE D'ÉTAT D'UN CONSTITUANT D'UNE INSTALLATION

(43) Veröffentlichungstag der Anmeldung: 26.03.2014
(73) Patentinhaber: Siemens Aktiengesellschaft, 80333 München (DE)
(72) Erfinder: HASSEL, Jörg, 91058 Erlangen (DE); RIEGER, Gotthard, 80636 München (DE); WEISS, Roland, 91058 Erlangen (DE); WIEGAND, Hermann-Josef, 36169 Rasdorf (DE)
(86) Internationale Anmeldenummer: PCT/EP2011/064228
(87) Internationale Veröffentlichungsnummer: WO 2013/023700

(56) Entgegenhaltungen:
- DE-A1-102006 019 483
- DE-A1-102007 040 399
- VEERARAGHAVAN G ET AL: "Magnetic field effects on current, electroluminescence and photocurrent in organic light-emitting diodes", JOURNAL OF PHYSICS: CONDENSED MATTER, INSTITUTE OF PHYSICS PUBLISHING, BRISTOL, GB, Bd. 19, Nr. 3, 24. Januar 2007 (2007-01-24), Seite 36209, XP020117737, ISSN: 0953-8984, DOI: 10.1088/0953-8984/19/3/036209

## Beschreibung

Die Erfindung betrifft eine Vorrichtung zur Zustandsüberwachung eines potentiell stromdurchflossenen Anlagenbestandteils einer industriellen Anlage, insbesondere eines elektrischen Stromleiters.

Die visuelle Darstellung einer momentanen Stromfreiheit oder Stromführung von elektrischen Leitern ist aus Sicherheits- und auch aus funktionalen Gründen in vielen elektrischen Geräten und Anlagen sowie Schaltschränken, z. B. in der Mittelspannungstechnik notwendig.

Heutige Lösungen basieren auf verschiedenen Sensorprinzipien für Strom oder Spannung, deren Ausgangssignale zur Zustandsüberwachung üblicherweise auf der Ausgabe einer elektrischen Größe (Spannung, Strom, Widerstand) im Niederspannungsbereich beruhen (Wandler). Diese wird üblicherweise an ein Ausgabegerät gesendet und entsprechend visualisiert (Lampen, Display). Da die Messung des Stromes durch diese Sensoren lokal erfolgt, muss je nach Stromlauf an mehreren Stellen oder Abzweigen gemessen werden. Eine unmittelbare optische lokale Zuordnung ist daher nicht möglich.

Ein organo-magnetoresistiver Sensor und Verwendung dazu ist bereits aus der DE 10 2006 019 483 bekannt. Ein XMR Sensor zur elektrischen Leistungsaufnahme ist aus der DE 10 2007 040 399 bekannt.

Es ist Aufgabe der vorliegenden Erfindung, eine Verfahren und eine Vorrichtung anzugeben, welche eine Überwachung des Zustands potentiell stromdurchflossener Anlagenbestandteile ermöglicht, und dabei die genannten Nachteile vermeidet.

Die Aufgabe wird durch eine Vorrichtung gemäß Patentanspruch 1 und durch ein Verfahren gemäß Patentanspruch 8 gelöst.

Die erfindungsgemäße Vorrichtung weist zum Erfassen des aktuellen Zustands des Anlagenbestandteils eine mit den zu überwachenden Anlagenbestandteil verbundene Felderzeugungseinrichtung auf, welche in einer Umgebung des Anlagenteils ein magnetisches Feld erzeugt, sowie ein organisches, magnetoresistives OMR-Halbleiterelement, welches ortsfest in der Umgebung des zu überwachenden Anlagenbestandteiles angeordnet ist und eine Spannungsquelle zum Erzeugen einer elektrischen Spannung zwischen zwei Elektroden des OMR-Halbleiterelements.

Beim erfindungsgemäßen Verfahren zum Ermitteln eines Zustandes eines potentiell stromführenden Anlagenbestandteiles, insbesondere eines elektrischen Leiters einer technischen Anlage wird ein magnetisches Feld erzeugt, welches in einer Umgebung des Anlagenbestandteils mittels eines organischen, magnetoresistiven OMR-Halbleiterelements erfasst wird. In Abhängigkeit von dem erfassten magnetischen Feld wird eine elektrischen Größe mittels des Halbleiterelements eingestellt.

Vorteilhafte Weiterbildungen der erfindungsgemäßen Vorrichtung sind durch die Unteransprüche gegeben.

Mit der erfindungsgemäßen Vorrichtung lässt sich der aktuelle Zustand, insbesondere der Stromdurchfluß in folgender Weise gemäß dem erfindungsgemäßen Verfahren ermitteln. Durch die Felderzeugungseinrichtung wird auf dem Anlagenbestandteil ein magnetisches Feld in Abhängigkeit erzeugt. Dieses Feld wird in der Umgebung des Anlagenbestandteils mittels des OMR-Halbleiterelements erfasst. Hierdurch wird es ermöglicht, mittels des OMR-Halbleiterelements eine elektrische Größe in Abhängigkeit von dem erfassten magnetischen Feld einzustellen. Bei dieser elektrischen Größe kann es sich beispielsweise um die zwischen den Elektroden abfallende elektrische Spannung oder einen durch sie hervorgerufenen elektrischen Strom handeln.

Die erfindungsgemäße Vorrichtung und das erfindungsgemäße Verfahren weisen die Vorteile auf, dass eine Anzeige einfach und preisgünstig auf nahezu beliebige Anlagenteile aufgebracht werden kann, auch nachträglich bei bereits bestehenden Anlagen. Eine entsprechende Anzeige zeigt lokal beschränkt auf einfachste Weise die gewünschte Information (ist der elektrische Leiter derzeit mit Strom belegt) an, eine zusätzliche Auswertung ist nicht erforderlich.

Das OMR-Halbleiterelement kann als Schicht ausgebildet sein, welche den elektrischen Leiter oder das gewünschte Anlagenbauteil zumindest bereichsweise umgibt. Hierdurch wird das magnetische Feld mittels des OMR-Halbleiterelements im Vergleich zu einer Erfassung mit einem Hall-Sensor oder einem AMR-Sensor verhältnismäßig großflächig erfasst. Daraus ergeben sich bei der Messung Mittelungseffekte, welche für ein schwankungsarmes Messsignal sorgen. Eine bevorzugte Ausführungsform der erfindungsgemäßen Vorrichtung weist ein OMR-Halbleiterelement auf, das die Form eines Hohlzylinders aufweist, Dieses hohlzylindrische OMR-Halbleiterelement umgibt dabei den Leiter in Umfangsrichtung, so dass eine Schwankung des Messsignals, wirkungsvoll unterdrückt ist. Als ebenfalls günstig kann sich ein OMR-Halbleiterelement in Form eines Segments eines Hohlzylinder erweisen, da sich dieses (beispielsweise zu Reparaturzwecken) mit geringem Aufwand entfernen lässt.

Ein weiterer Vorteil ergibt sich, wenn das OMR-Halbleiterelement auf einem flexiblen Substrat angeordnet ist. Dies lässt eine sehr einfache, platzsparende Konstruktion eines Gehäuses der Vorrichtung zu und ermöglicht eine einfache, kostengünstige Montage der Sensorik.

Eine andere Weiterbildung der erfindungsgemäßen Vorrichtung sieht eine Messeinrichtung zum Messen einer Größe vor, die zu einem durch das OMR-Halbleiterelement fließenden Strom und/oder einer an dem OMR-Halbleiterelement anliegenden Spannung proportional ist. Diese Größe können beispielsweise der Strom bzw. die Spannung selber sein oder eine elektrische Spannung, die über einem weiteren Element abfällt, das von demselben Strom durchflossen wird wie das OMR-Halbleiterelement. Auf der Grundlage eines Messsignals für die Größe lässt sich in vorteilhafter Weise eine automatisierte Überwachung bereitstellen oder ein Steuersignal für eine Anzeige bilden.

Ein besonders guter Messeffekt ergibt sich, wenn das OMR-Halbleiterelement mit einer konstanten Spannung innerhalb eines Betriebsbereichs betrieben wird, in welchem das OMR-Halbleiterelement eine maximale Feldempfindlichkeit aufweist. Entsprechend sieht eine vorteilhafte Weiterbildung der erfindungsgemäßen Vorrichtung vor, dass die Spannungsquelle als Konstantspannungsquelle ausgelegt ist. Die Feldempfindlichkeit gibt hierbei die Änderung dR des elektrischen Widerstands des OMR-Halbleiterelement bezogen auf eine Änderung der magnetischen Feldstärke dH an, also dR/dH.

Gemäß einer anderen, vorteilhaften Weiterbildung der erfindungsgemäßen Vorrichtung ist durch das OMR-Halbleiterelement eine OLED gebildet, das heißt eine organische Leuchtdiode (OLED - organic light emitting diode). Dies ist durch eine entsprechende Wahl des für die Herstellung des OMR-Halbleiterelements verwendeten organischen Halbleitermaterials erreichbar. Mittels einer OLED wird auf eine einfach zu realisierende Weise eine visuelle Darstellung der auf dem elektrischen Leiter oder Anlagenbauteil vorhandenen Stromführung ermöglicht.

Eine andere vorteilhafte Art einer optischen Anzeige ist gegeben, wenn die elektrische Spannung, die zwischen den Elektroden der OLED erzeugt wird, auf einen Wert eingestellt ist, bei welchem die OLED nur leuchtet, falls der gemessene Wert ein vorbestimmtes Kriterium erfüllt.

In einer weiteren vorteilhaften Ausgestaltungsform wird das OMR-Halbleiterelement oder OLED reversibel an dem Anlagenbestandteil angebracht. Mit reversibel ist hier umschrieben, dass die entsprechende Vorrichtung entsprechend ausgestattet ist, dass sie problemlos und rückstandsfrei, also nicht fest fixiert, an dem Anlagenteil befestigbar ist, insbesondere ausgeführt als Band und insbesondere mit integrierter Stromversorgung. Die konkrete Ausgestaltung kann in der Form z. B. als Klippband oder Klebeband erfolgen

Die Erfindung wird im Folgenden anhand von konkreten Ausführungsbeispielen beschrieben. Dazu zeigt:
- FIG 1a, b: schematische Darstellungen eines Sensors gemäß zweier Ausführungsformen der erfindungsgemäßen Vorrichtung,
- FIG 2: einen prinzipiellen Verlauf von Kennlinien einer OLED,
- FIG 3a, b: schematische Darstellungen zweier Ausführungsformen der erfindungsgemäßen Vorrichtung in unterschiedlicher Ausgestaltung und
- FIG 4: eine beispielhafte Anwendung der erfindungsgemäßen Vorrichtung in einer industriellen Anlage.

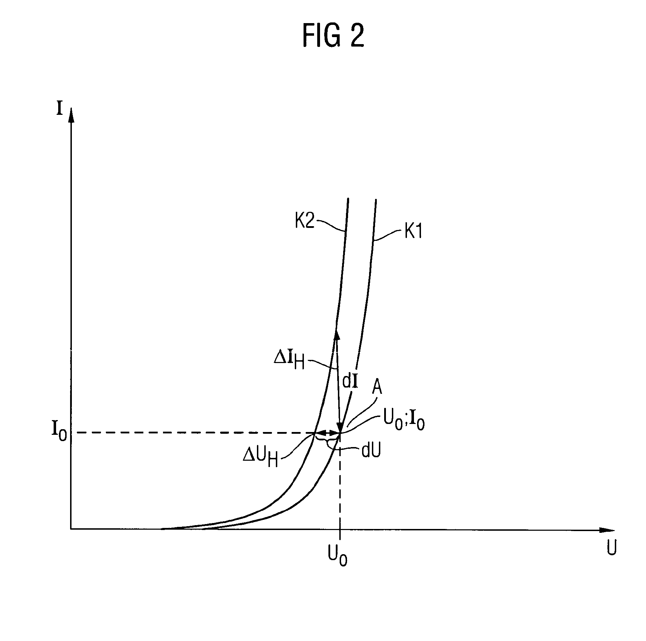

Die einfache visuelle Darstellung der Stromführung beruht auf den Eigenschaften OMR-Halbleiterelemente oder organisch magnetoresistiver lichtemittierender Dioden (OLEDs) und des physikalischen Zusammenhangs von Strom I und Magnetfeld, wie in Figur 2 dargestellt.

Jeder Stromfluß I erzeugt nach dem Durchflutungsgesetz ein magnetisches Wirbelfeld H. Bei Überschreiten einer gewissen Feldstärke emittiert das OMR-Halbleiterelement / im Folgenden kurz als die OLED bezeichnet, im sichtbaren Bereich (farbig). In einem einfachen Bild lässt sich das Funktionsprinzip bei einer konstanten Spannungsversorgung der OLED daher wie folgt darstellen:
mit einer konstanten Steuerspannung, 28, wird die OLED, 22, knapp unter der Stromschwelle zur gut sichtbaren Emission von Licht gehalten (Photoluminiszenz Schwelle). Durch das äußere Magnetfeld wird der Stromfluss in der OLED durch den OMR-Effekt soweit erhöht, dass ein gut sichtbarer Leuchteffekt entsteht. Damit ist ohne ein weiteres technisches Hilfsmittel zur Darstellung des Stromflusses eine Visualisierung längs der gesamten beschichteten elektrischen Verbindung möglich.

Die auf der Hülse 22 befindliche Schicht aus dem organischen Halbleitermaterial ist über zwei Elektroden 24, 26 mit einer Spannungsquelle 28 elektrisch verbunden. Die Spannungsquelle 28 erzeugt zwischen den Elektroden 24, 26 eine elektrische Spannung U mit dem Spannungswert U0. Für den Fall, dass kein Strom auf dem Leiter fließt, fließt hierdurch durch die OLED ein elektrischer Strom I mit der Stromstärke I0. Dies entspricht einem Arbeitpunkt A auf einer U/I-Kennlinie K1 des organischen Halbleitermaterials. Eine Kennlinie K2 ergibt sich, wenn das organische Halbleitermaterial von einem magnetischen Feld mit einer bestimmten, größeren Feldstärke durchdrungen wird. Hierdurch steigt für den Fall, dass die Spannungsquelle 28 eine konstante Spannung U mit dem Spannungswert U0 erzeugt, der Strom I um einen Stromstärkewert dI. Wird durch die Spannungsquelle 28 dagegen ein konstanter Strom I mit der Stromstärke I0 erzeugt, so verringert sich die Spannung U um einen Spannungswert dU.

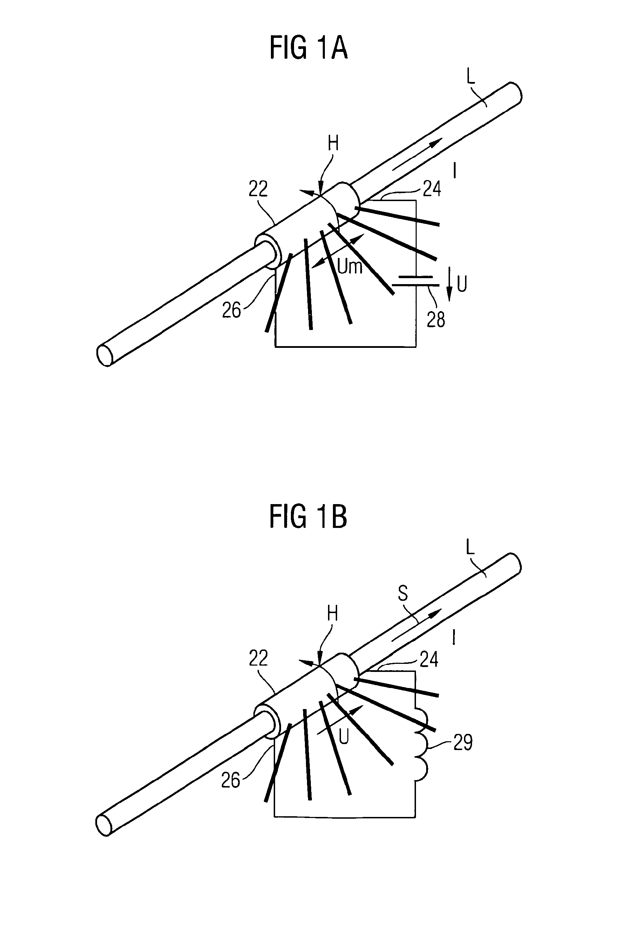

Wird als Spannungsquelle 28 eine Konstantspannungsquelle, beispielsweise eine Batterie, verwendet, ist es möglich, zur quantitativen Messung des Magnetfelds eine Stromerhöhung dI von ca. zehn bis dreißig Prozent bezogen auf 10 mittels der in den Figuren 1a und 1b gezeigten Anordnungen zu erhalten. Dies ermöglicht eine sehr genaue Messung der Änderung der magnetischen Feldstärke.

Der Strom I und die Spannung Um sind elektrische Größen, die durch den magnetoresistiven Effekt von der OLED in Abhängigkeit von dem magnetischen Feld verändert werden. Anstelle der Spannung Um kann durch die Messschaltung auch ein Messstrom gemessen werden.

Das organische Halbleitermaterial stellt eine OLED dar, welche leuchtet, wenn die Stromstärke des durch sie fließenden Stromes I einen bestimmten Stromstärkewert überschreitet. Die Spannung U der Spannungsquelle 28 ist in der Weise eingestellt, dass der Leuchteffekt dann einsetzt, wenn der auf die Welle 14 wirkende Stromfluss größer als ein voreingestellter maximal zulässiger Wert ist. Hierdurch wird einer Bedienperson der Anlage A dann unmittelbar durch luminiszierende Bereiche L1 bis L12 der OLED angezeigt, dass auf dem Leiter L ein Strom I fließt.

In einer Ausführungsform kann zum Bilden einer Schicht das organische Halbleitermaterial auf ein flexibles Substrat aufgetragen. Dabei kann es sich beispielsweise um Polyethylen (PET) oder um ein Polyimide (PI) handeln, wie es etwa unter der Bezeichnung Kepton erhältlich ist.

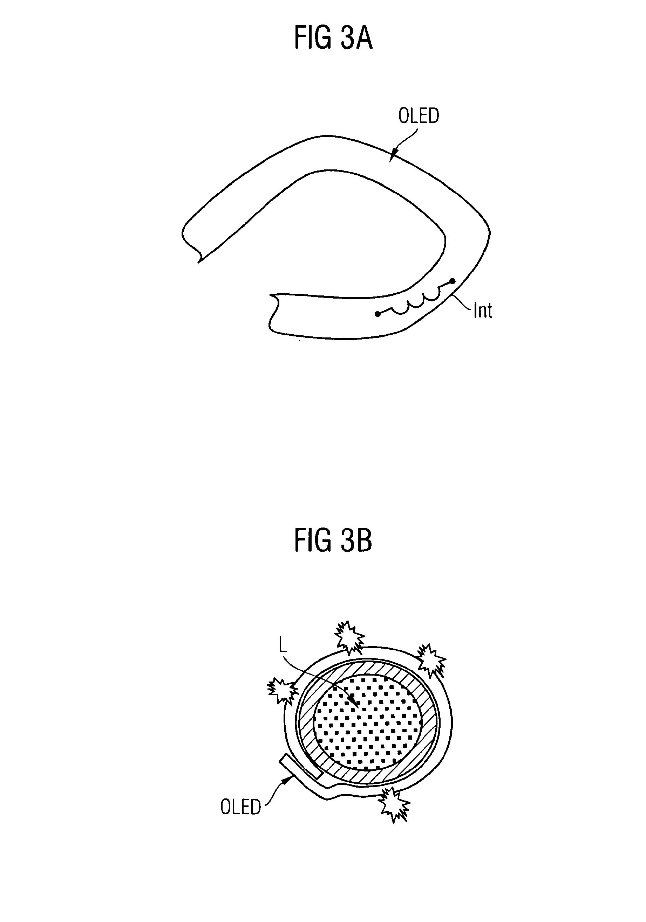

In einer in Figur 3a dargestellten Ausführungsform kann das OMR-Halbleiterelement / die OLED als Band mit integrierter Stromversorgung Int ausgeführt werden. Konkret kann dies in der Form z. B. auch als Klippband oder Klebeband OLED erfolgen, Figur 3b.

In dieser Form kann es nachträglich, ohne Eingriffe in eine bestehende Installation, an den zu überwachenden Leiterungen, in der Figur im Querschnitt dargestellt, L, befestigt und nach Bedarf auch wieder entfernt werden. Hiermit kann bereits die Inbetriebnahme bzw. Fehlersuche auch durch gleichzeitige parallele Überwachung des Stromflusses, in einer Anlage erheblich erleichtert werden.

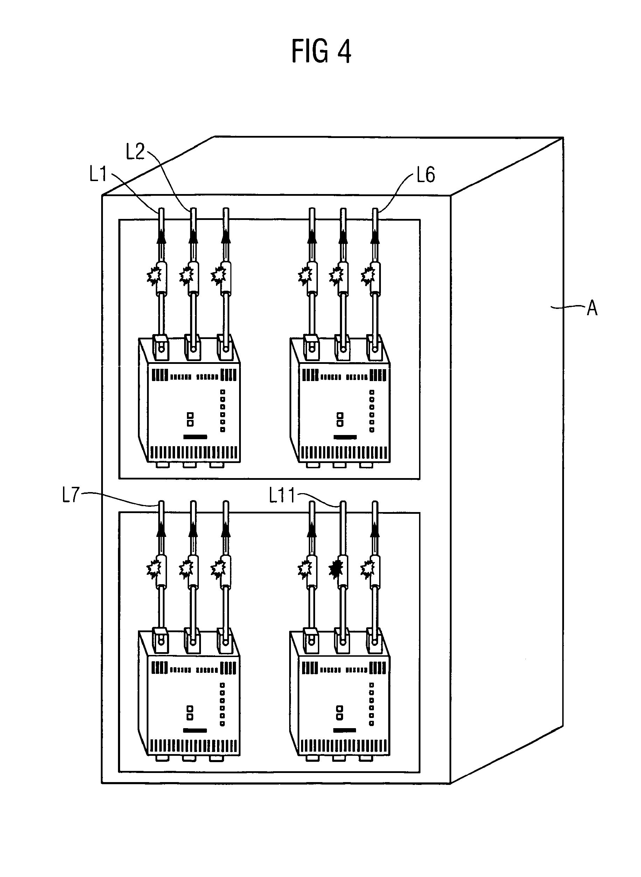

Durch eine flächige und durchgehende Beschichtung stromführender Anlagenteile z. B. des Leiters und des eindeutigen lokalen Zusammenhangs der Lichtemission mit der Stromstärke ist eine unmittelbare Information längs der gesamten Stromführung gegeben, vergleiche eine beispielhafte Darstellung einer industriellen Anlage A in Figur 4. Dies erlaubt eine schnelle Erfassung des Betriebszustands respektive des Stromdurchflusses der einzelnen Leitungen und damit hohe Sicherheit bei der Bewertung der Stromführung am stromführenden Anlagenteilen. Die um die betroffenen Leiter geführten Hülsen bzw die auf die betroffenen Leiter aufgebrachte Beschichtungen leuchten, L1 - L10, L12 wenn ein Stromfluß vorhanden ist, bzw. leuchten nicht, L11. So kann bei einer Funktionsstörung mit einem Blick und ohne weitere Auswertungswerkzeuge erfasst werden, beispielsweise ob eine Störung in der Stromversorgung vorliegt.

## Patentansprüche

1. Vorrichtung zum Ermitteln eines Zustandes eines potentiell stromführenden Anlagenbestandteiles (L), insbesondere eines elektrischen Leiters einer technischen Anlage mit
- einer mit den zu überwachenden Anlagenbestandteil (L) verbundene Felderzeugungseinrichtung (L), welche in einer Umgebung des Anlagenteils ein magnetisches Feld (H) erzeugt,
- einem organischen, magnetoresistiven OMR-Halbleiterelement (22), welches ortsfest in der Umgebung des zu überwachenden Anlagenbestandteiles (L) angeordnet istund
- einer Spannungsquelle (28, 29) zum Erzeugen einer elektrischen Spannung zwischen zwei Elektroden (24, 26) des OMR-Halbleiterelements**dadurch gekennzeichnet, dass** die Spannungsquelle (28) als Konstantspannungsquelle ausgelegt ist und das OMR-Halbleiterelement so eingerichtet ist, dass es mit einer konstanten Spannung innerhalb eines Betriebsbereichs betrieben wird, in welchem das OMR-Halbleiterelement eine maximale Feldempfindlichkeit aufweist.

2. Vorrichtung nach Anspruch 1, bei welcher das OMR-Halbleiterelement (22) als Schicht ausgebildet ist, welche das stromführende Anlagenbestandteil (L) zumindest bereichsweise umgibt, wobei sie die Form eines Hohlzylinders oder eines Segment eines Hohlzylinders aufweist.

3. Vorrichtung nach Anspruch 1 oder 2, bei welcher das OMR-Halbleiterelement (22) auf einem flexiblen Substrat angeordnet ist.

4. Vorrichtung nach einem der vorhergehenden Ansprüche, welche eine Messeinrichtung zum Messen einer Größe (Um) aufweist, die zu einem durch das OMR-Halbleiterelement fließenden Strom (I) und/ oder einer an dem OMR-Halbleiterelement anliegenden Spannung (U) proportional ist.

5. Vorrichtung nach einem der vorhergehenden Ansprüche, bei welcher durch OMR-Halbleiterelement (22) eine OLED gebildet ist, wobei die elektrischen Spannung (U) bevorzugt auf einen Wert (U0) eingestellt ist, bei welchem die OLED nur leuchtet, falls das zu überwachende Anlagenbestandteil ein vorbestimmtes Kriterium erfüllt.

6. Vorrichtung nach einem der Ansprüche 3 bis 5, bei welcher das OMR-Halbleiterelement (22) reversibel an dem Anlagenbestandteil angebracht ist, insbesondere in Form eines Klipp-, Klett oder Klebebandes (OLED).

7. Verfahren zum Ermitteln eines Zustandes eines potentiell stromführenden Anlagenbestandteiles (L), insbesondere eines elektrischen Leiters einer technischen Anlage mit folgenden Schritten
- auf dem Anlagenbestandteil Erzeugen eines magnetischen Felds (H),
- Erfassen des magnetischen Felds (H) in einer Umgebung des Anlagenbestandteils mittels eines organischen, magnetoresistiven OMR-Halbleiterelements (22),mit einer Konstantspannungsquelle (28, 29) zum Erzeugen einer elektrischen Spannung zwischen zwei Elektroden (24, 26) des OMR-Halbleiterelements, so dass das OMR-Halbleiterelement mit einer konstanten Spannung innerhalb eines Betriebsbereichs betrieben wird, in welchem das OMR-Halbleiterelement eine maximale Feldempfindlichkeit aufweist
- Einstellen einer elektrischen Größe (Um) in Abhängigkeit von dem mittels des Halbleiterelements erfassten magnetischen Feldes (H).

8. Verfahren nach Patentanspruch 7, **dadurch gekennzeichnet, dass** eine Darstellung des ermittelten Zustandes erfolgt, in dem durch das OMR-Halbleiterelement eine OLED gebildet ist, und die elektrischen Spannung (U) bevorzugt auf einen Wert (UO) eingestellt ist, bei welchem die OLED nur leuchtet, falls das zu überwachende Anlagenbestandteil ein vorbestimmtes Kriterium erfüllt.

## Claims

1. Apparatus for determining a state of a potentially current-carrying installation component (L), in particular of an electrical conductor of a technical installation, comprising:
- a field generating device, which is connected to the installation component (L) to be monitored and which generates a magnetic field (H) in a vicinity of the installation part,
- an organic magnetoresistive OMR semiconductor element (22), which is arranged in a stationary manner in the vicinity of the installation component (L) to be monitored, and
- a voltage source (28, 29) for generating an electrical voltage between two electrodes (24, 26) of the OMR semiconductor element, **characterized in that** the voltage source (28) is designed as a constant-voltage source and the OMR semiconductor element is designed such that it is operated with a constant voltage within an operating range in which the OMR semiconductor element has a maximum field sensitivity.

2. Apparatus according to Claim 1, wherein the OMR semiconductor element (22) is embodied as a layer surrounding the current-carrying installation component (L) at least in regions, said layer having the form of a hollow cylinder or of a segment of a hollow cylinder.

3. Apparatus according to Claim 1 or 2, wherein the OMR semiconductor element (22) is arranged on a flexible substrate.

4. Apparatus according to any of the preceding claims, which comprises a measuring device for measuring a variable (Um) proportional to a current (I) flowing through the OMR semiconductor element and/or a voltage (U) present at the OMR semiconductor element.

5. Apparatus according to any of the preceding claims, wherein an OLED is formed by the OMR semiconductor element (22), the electrical voltage (U) preferably being set to a value (U0) at which the OLED emits light only if the installation component to be monitored fulfills a predetermined criterion.

6. Apparatus according to any of Claims 3 to 5, wherein the OMR semiconductor element (22) is fitted to the installation component in a reversible manner, in particular in the form of a clip band, hook-and-loop strip or adhesive tape (OLED).

7. Method for determining a state of a potentially current-carrying installation component (L), in particular of an electrical conductor of a technical installation, comprising the following steps:
- generating a magnetic field (H) on the installation component,
- detecting the magnetic field (H) in a vicinity of the installation component by means of an organic magnetoresistive OMR semiconductor element (22), with a constant-voltage source (28, 29) for generating an electrical voltage between two electrodes (24, 26) of the OMR semiconductor element, such that the OMR semiconductor element is operated with a constant voltage within an operating range in which the OMR semiconductor element has a maximum field sensitivity,
- setting an electrical variable (Um) in a manner dependent on the magnetic field (H) detected by means of the semiconductor element.

8. Method according to Patent Claim 7, **characterized in that** the determined state is represented by virtue of the fact that an OLED is formed by the OMR semiconductor element, and the electrical voltage (U) is preferably set to a value (U0) at which the OLED emits light only if the installation component to be monitored fulfills a predetermined criterion.

## Revendications

1. Dispositif pour déterminer un état d'un constituant (L) d'une installation transportant potentiellement un courant, en particulier d'un conducteur électrique d'une installation technique, avec
- un dispositif de production de champ (L) relié au constituant à surveiller (L) de l'installation, qui produit un champ magnétique (H) dans un environnement du constituant de l'installation,
- un élément semi-conducteur OMR, organique, magnétorésistant (22), qui est disposé en position stationnaire dans l'environnement du constituant à surveiller (L) de l'installation, et
- une source de tension (28, 29) pour produire une tension électrique entre deux électrodes (24, 26) de l'élément semi-conducteur OMR,
**caractérisé en ce que** la source de tension (28) est une source à tension constante et l'élément semi-conducteur OMR est conçu de telle manière qu'il fonctionne avec une tension constante à l'intérieur d'un domaine de fonctionnement, dans lequel l'élément semi-conducteur OMR présente une sensibilité au champ maximale.

2. Dispositif selon la revendication 1, dans lequel l'élément semi-conducteur OMR (22) est réalisé sous la forme d'une couche, qui entoure au moins localement le constituant conducteur de courant (L) de l'installation, dans lequel il présente la forme d'un cylindre creux ou d'un segment d'un cylindre creux.

3. Dispositif selon la revendication 1 ou 2, dans lequel l'élément semi-conducteur OMR (22) est disposé sur un substrat flexible.

4. Dispositif selon l'une quelconque des revendications précédentes, qui comporte un dispositif de mesure pour mesurer une grandeur (Um), qui est proportionnelle à un courant (I) circulant à travers l'élément semi-conducteur OMR et/ou à une tension (U) appliquée à l'élément semi-conducteur OMR.

5. Dispositif selon l'une quelconque des revendications précédentes, dans lequel une OLED est formée par l'élément semi-conducteur OMR (22), dans lequel la tension électrique (U) est réglée de préférence à une valeur (U0), sous laquelle la OLED ne s'éclaire que dans le cas où le constituant à surveiller de l'installation remplit un critère prédéterminé.

6. Dispositif selon l'une quelconque des revendications 3 à 5, dans lequel l'élément semi-conducteur OMR (22) est placé de façon réversible sur le constituant de l'installation, en particulier sous la forme d'une bande à clipser, d'une bande velcro ou d'une bande adhésive (OLED).

7. Procédé pour déterminer un état d'un constituant (L) d'une installation transportant potentiellement un courant, en particulier d'un conducteur électrique d'une installation technique, comportant les étapes suivantes:
- production d'un champ magnétique (H) sur le constituant de l'installation,
- détection du champ magnétique (H) dans un environnement du constituant de l'installation au moyen d'un élément semi-conducteur OMR, organique, magnéto-résistant (22), avec une source à tension constante (28, 29) pour la production d'une tension électrique entre deux électrodes (24, 26) de l'élément semi-conducteur OMR, de telle manière que l'élément semi-conducteur OMR fonctionne avec une tension constante à l'intérieur d'un domaine de fonctionnement, dans lequel l'élément semi-conducteur OMR présente une sensibilité au champ maximale,
- réglage d'une grandeur électrique (Um) en fonction du champ magnétique (H) détecté au moyen de l'élément semi-conducteur.

8. Procédé selon la revendication 7, **caractérisé en ce qu'**il se produit une représentation de l'état déterminé, par le fait qu'une OLED est formée par l'élément semi-conducteur OMR et que la tension électrique (U) est réglée de préférence à une valeur (U0), sous laquelle la OLED ne s'éclaire que dans le cas où le constituant à surveiller de l'installation remplit un critère prédéterminé.
